# EUROPEAN PATENT APPLICATION

(11) **EP 4 312 375 A1**
(43) Date of publication of application: **31.01.2024**
(21) Application number: 22187546.1
(22) Date of filing: 28.07.2022
(51) Int. Cl.: H03L 7/081, H03M 1/06

(54) **FREQUENCY SYNTHESIZER AND METHOD FOR GENERATING AN RF CLOCK SIGNAL**

(71) Applicant: INTEL Corporation, Santa Clara, CA 95054 (US)
(72) Inventor: THALLER, Edwin, 9583 Faak am See (AT)
(74) Representative: 2SPL Patentanwälte PartG mbB

(57) **Abstract**

A frequency synthesizer and a method for generating an RF clock signal. A system includes a plurality of transceivers. Each transceiver includes a digital-to-analog converter, an analog-to-digital converter, and a frequency synthesizer. A frequency synthesizer in each transceiver receives a first reference clock signal and a second, different, reference clock signal. The frequency synthesizer includes a digitally-controlled oscillator (DCO), a feedback loop circuitry, a phase alignment and clock generation circuitry. The DCO generates an RF clock signal that is synchronized with the first reference clock signal. The phase alignment and clock generation circuitry aligns the phase of the RF clock signal with a phase of the second reference clock signal. The second reference clock signal is a system-wide reference clock signal for the plurality of transceivers.

## Description

### Background

Common trends in wireless transceivers are increased radio frequency (RF) frequencies and bandwidth, improved coverage and throughput, higher data rates, lower latency, better energy efficiency, or the like. These requirements are addressed by the adoption of massive multiple-input multiple-output (MIMO) and beamforming techniques. Typical working frequencies of massive MIMO radios are 2.6 GHz and above. These frequencies have degraded penetration inside buildings and difficulties to reach outdoor areas, resulting in the requirement for small cells and large cell count. Therefore, the availability of cost effective and easy to install small cells are a key for wide enablement of Fifth Generation (5G) wireless communication systems.

The large number of antennas in a beamforming massive MIMO system are usually arranged as an array. Each antenna of the antenna array requires precise control of amplitude and phase of the RF signal during transmission and reception. This necessitates precisely phase controlled RF transmitter/receiver (TX/RX) chains. Each TX/RX chain comprises an analog-to-digital converter (ADC) for the RX direction and a digital-to-analog converter (DAC) for the TX direction. All the converters (e.g., ADCs and DACs) within the system need to be precisely aligned in phase with respect to the RF clock signal (e.g., a converter sampling clock for direct RF-sampling ADC/DAC, a mixer clock for mixer-based transceivers, etc.), the converter (ADC/DAC) device clock, the digital data (e.g., data and numerically controlled oscillators (NCOs) in digital up-converter/digital down-converter (DUC/DDC)). The phase needs to be long-term stable and deterministic over temperature variation and power cycles.

A large number of converters and processing components may be distributed over multiple microchips. Each microchip may include numerous converters and a dedicated phase-locked loop (PLL) for locally generating the RF converter sampling clocks (for direct RF-sampling systems) or the RF local oscillator (LO) signals for mixers (for direct conversion transceiver systems), etc. The RF clocks generated by the PLLs need to be coherent across the system.

### Brief description of the Figures

Some examples of apparatuses and/or methods will be described in the following by way of example only, and with reference to the accompanying figures, in which
FIG. 1 is a high-level block diagram of an example multi-channel, multi-antenna system;
FIG. 2 shows one example scheme of multi-chip synchronization for a multi-converter system;
FIG. 3 shows an example multi-chip synchronization scheme implemented in a massive multiple-input multiple-output (MIMO) system based on multi-channel transceiver system-on-chips (SOCs);
FIG. 4 shows one example of conventional PLL LO synchronization, as implemented in a PLL;
FIG. 5 is a schematic block diagram of an example frequency synthesizer in accordance with one example;
FIG. 6 shows an example transceiver system and RF front-end components;
FIG. 7 shows a schematic diagram of an example digital PLL (DPLL);
FIG. 8 shows a block diagram of an example DPLL in accordance with one example;
FIG. 9 is a flow diagram of an example method for generating an RF clock signal;
FIG. 10 illustrates a user device in which the examples disclosed herein may be implemented; and
FIG. 11 illustrates a base station or infrastructure equipment radio head in which the examples disclosed herein may be implemented.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

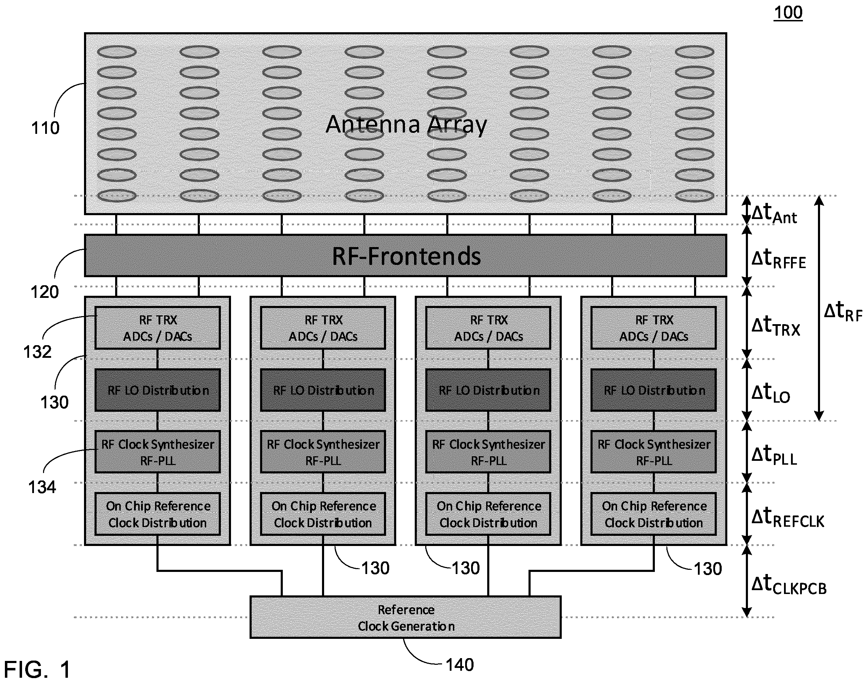

FIG. 1 is a high-level block diagram of an example multi-channel, multi-antenna system 100. FIG. 1 also shows the sources of phase imperfections in the system 100. The system 100 includes an antenna array 110, RF front-end circuitry 120, a plurality of transceiver units 130 (e.g., chips), and a reference clock generation block 140. The antenna array 110 includes a plurality of antennas/antenna elements. RF signals are routed from the antenna array 110 to the RF front-end circuitry 120 and then to the transceiver units 130, and vice versa. A reference clock signal is generated by the reference clock generation block 140 and distributed to the transceiver units 130. Each transceiver unit 130 may include one or more transceivers 132 and a phase locked loop (PLL) 134. The PLL 134 in each transceiver unit 130 may generate an RF clock signal for the transceivers based on the reference clock signal provided from the reference clock generation block 140.

The overall phase of the RF signal at the antenna is determined by numerous delays, including the printed circuit board (PCB) level reference clock routing (t_{CLKPCB}), the on-chip reference path (t_{REFCLK}), PLL (t_{PLL}), and RF path (t_{RF}) delay. The RF path delay is the sum of the on-chip LO-distribution (t_{LO}) and RF data converter (t_{TRX}) delays and the off-chip delays through the RF-frontend (t_{RFFE}) and antenna path routing (t_{ANT}). In beam forming/MIMO systems, a system level antenna calibration is performed to equalize the sum of all these paths delays between all channels.

A transceiver chip side phase coherence across all channels within a single transceiver chip (a multi-transceiver chip) and across all transceivers of the system is targeted for reduction of antenna calibration complexity by initializing to a more consistent startup condition with deterministic PLL RF clock phase, reducing the temperature dependence of the system phase synchronization to allow the antenna calibration to run less frequently during operation, and allowing transceivers to be stopped and started in an operational system and "hot synchronize" with the other transceiver elements.

For the transceiver phase coherence, PLL local oscillator (LO) phase coherence is needed across all PLLs in the system. The PLL LO phase synchronization addresses the PLL phase and reduces their temperature dependence to a negligible amount compared to other sources of phase drift in the system.

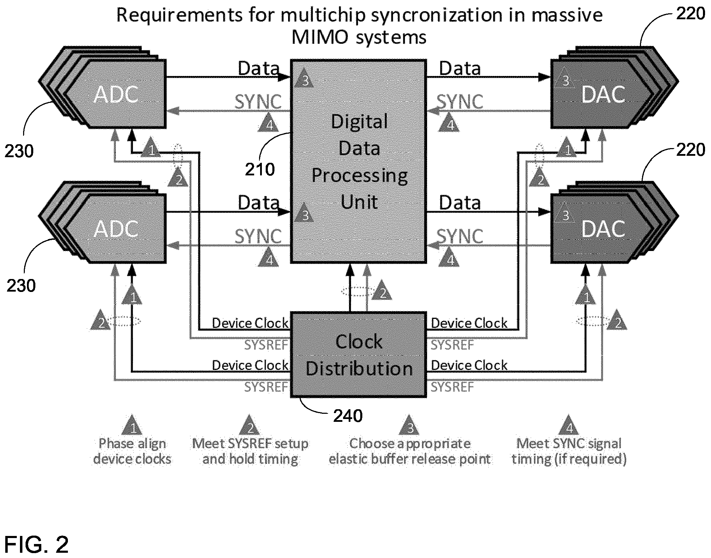

FIG. 2 shows one example scheme of multi-chip synchronization for a multi-converter system (e.g., a massive MIMO system). FIG. 2 also shows requirements for multichip synchronization for a multi-converter system. A data processing unit 210 transmits and receives data to and from a plurality of DACs 220 and ADCs 230, respectively. The clock distribution block 240 distributes a device clock and a system reference clock (SYSREF) to the data processing unit 210, the ADCs 230, and the DACs 220. In this implementation, the device clocks for the converters (i.e., ADCs 230 and DACs 220) are distributed in a delay matched way. The device clocks can be either the converter sampling clocks or the PLL reference clocks for generating the converter sampling clocks in case of integrated PLLs. Synchronization among the converters 220, 230 and the data processing unit 210 is implemented over the system reference clock (SYSREF) signals which are also distributed delay matched. The system reference clock signal is sampled with the device clock on the converter side and with a digital clock in the data processing unit 210. The device clock and the digital clock in the data processing unit 210 need to be properly aligned with the system reference clock to meet the setup/hold time requirement at the sampling point of the system reference clock. In this example, the alignment may be achieved through clock distribution buffers with a programmable delay as part of the clock distribution.

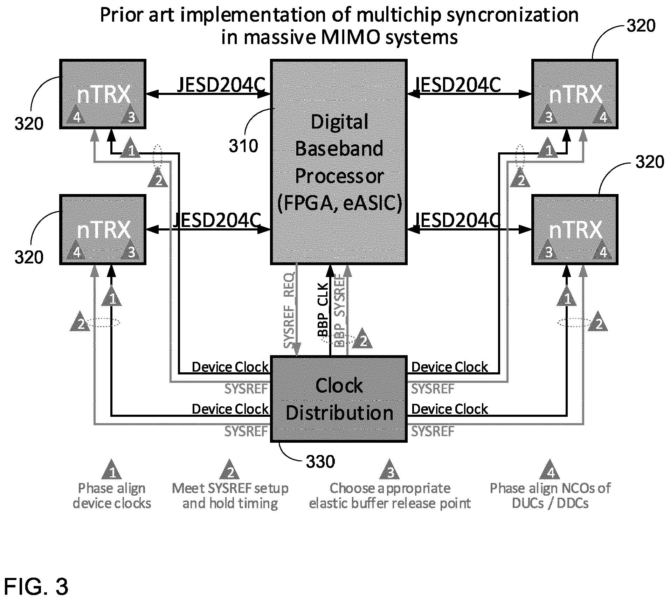

The demand for many TX and RX channels in a current massive MIMO and beamforming wireless transceivers is addressed by complex RF transceiver system-on-chips (SOCs) containing multiple wideband ADCs and DACs monolithically integrated with digital signal processing (DSP) blocks and frequency synthesizers (PLLs). FIG. 3 shows an example multi-chip synchronization scheme implemented in a massive MIMO system based on multi-channel transceiver SOCs. A digital baseband processor 310 transmits/receives to/from a plurality of transceiver chips 320. The clock distribution block 330 generates device clocks which are either sampling clocks for the converters or reference clocks for the integrated frequency synthesizers, a digital clock for the digital baseband processor 310, and system reference clock (SYSREF) signals.

The multi-chip synchronization requirements are the same as described above for the system in FIG. 2. The multi-chip synchronization scheme needs to fulfill the following target application requirements: 1) phase alignment of the device clocks (converter sampling clocks/synthesizer reference clocks/BBP clock), 2) individual PLL/frequency synthesizer phase adjustment possibility for compensation of thermal gradients within the system, 3) a system reference clock SYSREF with individually programmable delay for proper alignment to the device clocks in order to meet setup/hold timing, and 4) a clock distribution scheme with a clock tree that can provide the SYSREF pulse to all integrated circuit devices within the same sample clock cycle.

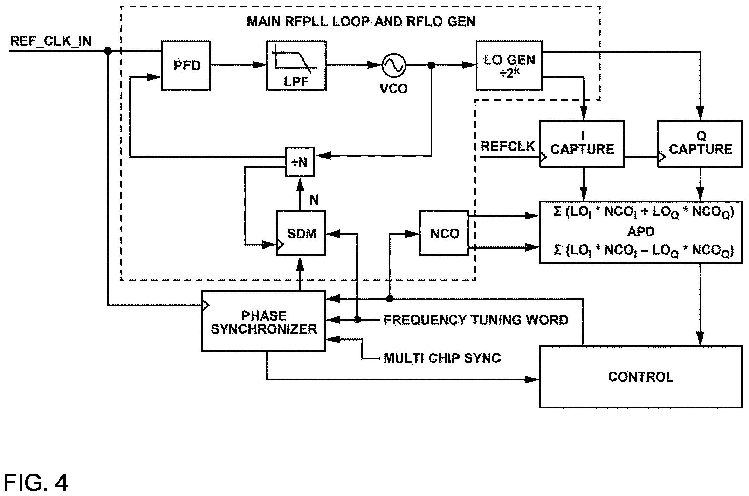

One example of conventional PLL LO synchronization, as implemented in a PLL which is part of a Quad RF-Transceiver chip is depicted in FIG. 4. In this example, the internally generated LO signal can be phase synchronized and aligned to the applied reference clock. Actual phase of the LO is detected through quadrature generation and sampling with the reference clock. Phase measurement accuracy is increased through averaging over many cycles of the reference clock. Adjustment of the LO phase is performed by adding an offset value to the first stage accumulator of the PLL sigma-delta modulator (SDM). In FIG. 4, phase adjustment of the LO is possible only in fractional mode PLL operation. In integer mode operation phase of the LO has a fixed relation to the reference clock.

Another example of a prior art PLL clock synthesizer for base-station applications relies on deterministic input to output clock phase relation in integer mode and phase adjustment capability in fractional mode operation. An input is provided for re-synchronization of multiple devices after startup. In any case, the phase reference for the output clock is the PLL reference clock.

Conventional systems for the transceiver phase coherence have some drawbacks. In conventional systems, the phase reference of the synthesizer RF clock signal is the PLL reference clock signal. In conventional systems, complex delay matched reference clock distribution scheme is needed on a system level, based on delay matched PCB traces and/or dedicated clock distribution buffers with a programmable delay. It can increase phase noise on a reference clock through additional clock distribution buffers. It needs difficult routing for complex delay matched clock tree, and complexity increases with the number of devices. It increases bill of material (BOM) for clock distribution buffers, and process and temperature dependence is device specific. In addition, dynamic temperature changes and gradients require re-adjustment of individual reference clock signal (REFCLK) delays. In some conventional solutions, phase adjustment only works if the PLL is in fractional mode operation as phase is adjusted via a phase offset value added to an accumulator of the sigma delta modulator (SDM) which controls the fractional feedback clock divider. In an integer mode operation, a deterministic input-to-output clock relation is assumed, which in a real system is subject to static variation due to device process mismatch and dynamic variation due to temperature gradients.

Hereafter, examples are disclosed for a method and system for generating an RF clock signal. In accordance with the examples, the RF clock signals of a plurality of PLLs in the system are phase aligned and the phase coherence of the RF clock signals can be maintained over time. The PLLs may reside on a single die or multiple dies in a package or may be distributed across multiple packages/chips. In examples, the RF clock signal generated by each PLL is phase-aligned to a dedicated system-wide reference signal, other than the PLL reference clock for each PLL. The clock synchronization schemes in accordance with the examples disclosed herein are applicable to a system having multiple frequency synthesizers (PLLs) which are required to operate deterministic, synchronous, and phase-aligned, for example in phased arrays and massive MIMO beamforming RF transceivers. The examples disclosed herein for phase aligning the frequency synthesizer (PLL) RF output clocks reduce system complexity, bill of material (BOM) for external clock distribution devices and improves phase stability over temperature gradients, resulting in less frequent re-calibration.

Hereafter, the examples will be explained in the context of digital PLL (DPLL). However, it should be noted that the examples can be implemented with an analog PLL operating in integer-N or fractional-N mode. The examples are applicable to the PLLs residing on a single die or multiple dies in single package or multiple packages.

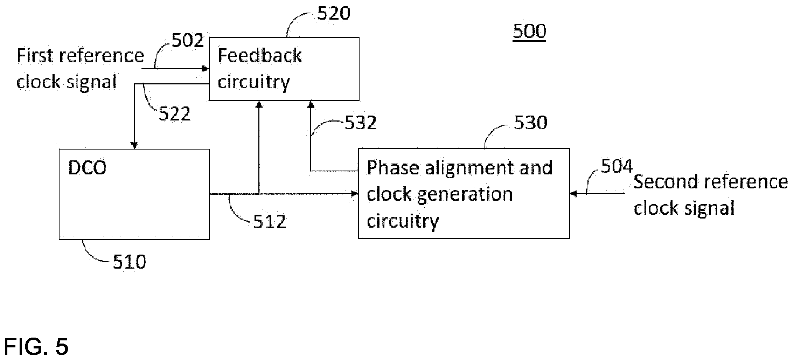

FIG. 5 is a schematic block diagram of an example frequency synthesizer 500 in accordance with one example. The frequency synthesizer 500 may be used in a system (e.g., a massive MIMO system) including a plurality of transceiver units. The plurality of transceiver units may be included in a single chip or multiple chips. The transceiver units may be configured to receive and transmit from and to a plurality of antennas. Each transceiver unit may include at least one DAC, at least one ADC, and a frequency synthesizer (e.g., a digital or analog PLL). The frequency synthesizer 500 in each transceiver unit may receive a first reference clock signal 502 and a second, different, reference clock signal 504. The first reference signal 502 is a PLL reference signal for the frequency synthesizer 500. The second reference clock signal 504 is a system-wide phase-synchronization signal (a system-wide reference clock signal) for the plurality of transceiver units. For example, the second reference clock signal 504 may be a low frequency reference signal (e.g. called SYSREF), which provides a system-level reference for sample timing, RF data frame synchronization, etc. The phase of the DCO is aligned relative to the second reference clock with a slow (low bandwidth) background phase control/tracking loop. The second reference clock signal does not necessarily have to be active all the time. It may be active only during system startup for an initial synchronization of multiple transceiver units, baseband processor(s), or other devices, or it may be active periodically during operation for system re-synchronization or it may be active occasionally during operation for system re-synchronization or it may be active all the time.

In examples, the frequency synthesizer 500 may include a digitally-controlled oscillator (DCO) 510, a feedback circuitry 520, and a phase alignment and clock generation circuitry 530. The DCO 510 is configured to generate an RF clock signal 512 based on the first reference clock signal 502. The RF clock signal generated by the DCO gets synchronized with the first reference signal via feedback from the feedback circuitry 520. The feedback circuitry 520 configured to measure timing relation between the RF clock signal 512 and the first reference clock signal 502 and send a feedback signal 522 to the DCO 510 to synchronize the RF clock signal 512 with the first reference clock signal 502. The first reference clock signal is the frequency reference for the PLL. The first reference clock is used for frequency locking the DCO to an integer or fractional multiple of the first reference clock.

The phase alignment and clock generation circuitry 530 is configured to measure timing relation between the RF clock signal 512 and the second reference clock signal 504 and align the phase of the RF clock signal 512 with a phase of the second reference clock signal 504 based on the measured timing relation between the RF clock signal 512 and the second reference clock signal 504. In examples, the feedback loop of the DCO 510 operates on the first reference clock signal, but the RF clock signal from the DCO is in-phase with the second reference clock signal.

The frequency synthesizer 500 may include a programmable delay configured to delay the RF clock signal 512 based on a control signal 532 from the phase alignment and clock generation circuitry 530. The phase alignment and clock generation circuitry 530 may generate a control signal 532 to adjust the phase of the RF clock signal 512 such that the RF clock signal 512 gets in phase with the second reference clock signal 504.

The programmable delay may be included in the feedback circuitry 520. The programmable delay may be included in the feedback path of the DCO 510 such that the RF clock signal provided to the feedback circuitry 520 for measuring the timing relation between the RF clock signal 512 and the first reference clock signal 502 may be delayed based on the control signal 532 from the phase alignment and clock generation circuitry 530. Alternatively, the programmable delay may be included in a signal path of the RF clock signal 512 to the at least one ADC and the at least one DAC. The programmable delay may be a digital-to-time converter (DTC).

In examples, the feedback circuitry 520 may include a time-to-digital converter (TDC) for measuring the timing relation between the RF clock signal 512 and the first reference clock signal 502. The TDC may include a chain of delay buffers and a plurality of flip-flops. The first reference clock signal 502 is input into the chain of delay buffers and the RF clock signal 512 is sampled to the plurality of flip-flops by the first reference clock signal 502 in the chain of delay buffers.

The phase alignment and clock generation circuitry 530 may be configured to generate at least one additional clock signal that is in phase with the second reference clock signal 504 and supply the at least one additional clock signal to the ADC and the DAC and/or to baseband processing components. The RF clock signal 512 may be distributed to the ADC and the DAC via a clock distribution tree.

The phase alignment and clock generation circuitry 530 may be configured to receive the second reference clock signal 504 from an external clock source or from another transceiver unit (i.e., another PLL) in the system. The phase alignment and clock generation circuitry 530 may be configured to send the second reference clock signal 504 to another transceiver unit in the system.

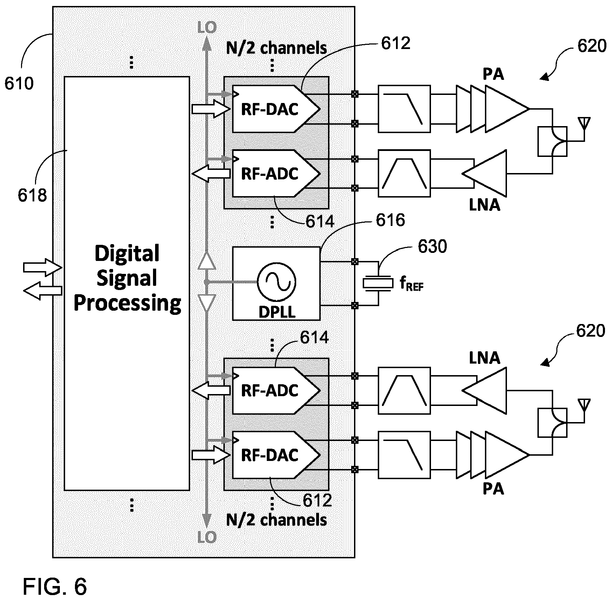

FIG. 6 shows an example transceiver system and RF front-end components. The transceiver system 610 may be included in a base-station radio transceiver system. In this example, the system 610 includes a plurality of direct RF-sampling data converters (ADCs 614 and DACs 612), an integrated DPLL 616 (i.e., a frequency synthesizer) for RF clock generation, and a digital baseband processor 618. The plurality of direct RF-sampling ADCs 614 and DACs 612 may be integrated on a single die with the DPLL 616 and the digital baseband processor 618.

The transceiver system 610 includes multiple transmit and receive channels (N channels). Each transmit channel includes a DAC 612 to convert a digital signal to an analog signal to be transmitted via the RF front-end 620, and each receive channel includes an ADC 614 to convert an analog signal received via the RF front-end 620 to a digital signal. The ADCs 614 and DACs 612 may be direct RF-sampling converters. The ADCs 614 and DACs 612 run at a sampling rate (e.g., up to 16 GHz) and may enable direct sampling or synthesis of RF signals at certain frequencies (e.g., up to about 6 GHz). The direct sampling ADCs 614 and DACs 612 may replace conventional RF components like mixers, local oscillators, and amplifiers.

The transceiver system 610 also includes a digital PLL (DPLL) 616 (alternatively analog PLL) for RF clock generation and a digital baseband processor 618 for baseband processing of the transmit/receive signals. The DPLL 616 generates an RF clock signal based on a reference clock 630 and supplies a sampling clock (the RF clock signal) to the ADCs 614 and DACs 612 and other processing components in the transceiver unit 610. The DPLL 616 needs to have an ultra-low phase noise and fulfill band emission mask requirements for the TX and RX to minimize self- and adjacent-channel mixing. In addition, strong suppression of reference and harmonic spurs is needed to meet the stringent out-of-band emission requirements.

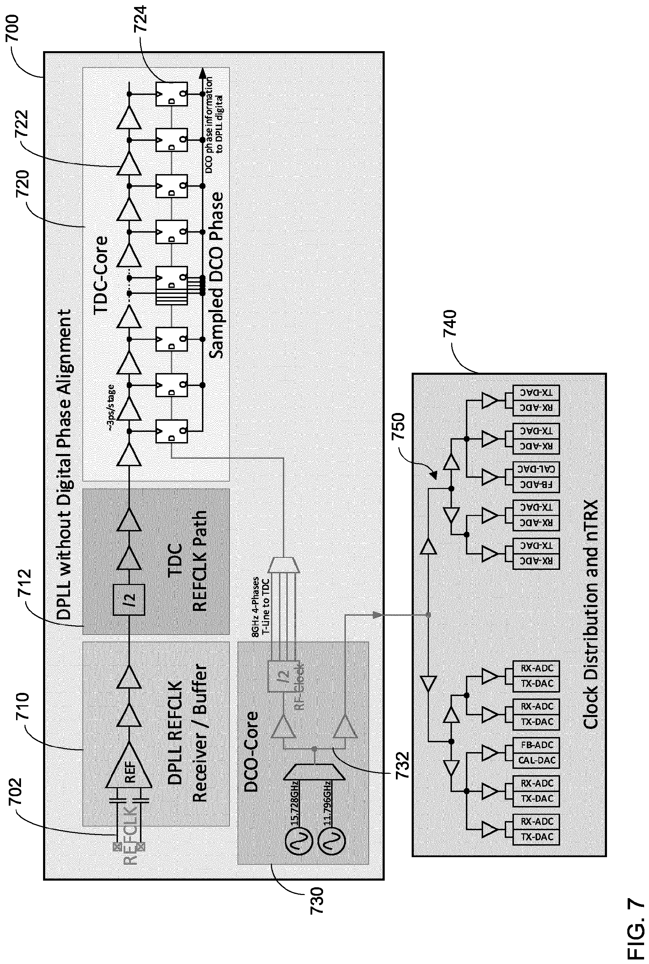

FIG. 7 shows a schematic diagram of an example DPLL. The DPLL 700 includes a reference clock receiver 710, a TDC 720, and a DCO 730. The DPLL 700 generates an RF clock signal 732 based on the reference clock signal 702. The RF clock signal 732 is distributed to the transceivers 740 via a clock distribution tree 750. The reference clock signal 702 is supplied to the TDC 720 via the reference clock receiver 710 and the TDC reference clock path 712. A copy of the RF clock signal 732 generated by the DCO 730 is supplied to the TDC 720. As shown in FIG. 7, the RF clock signal 732 may be divided by a clock divider (by 2 in this example shown in FIG. 7). The TDC reference clock path 712 may also include a clock divider (by 2 in this example). Alternatively, the RF clock signal 732 or the reference clock signal 702 may not be divided or may be divided by a different factor other than two. The TDC 720 includes a chain of delay gates 722 and a plurality of flip-flops 724. The reference clock signal 702 propagates through the chain of delay gates 722. The RF clock signal 734 is supplied to the inputs of the flip-flops 724 and sampled into the flip-flops by the delayed chain of reference clock signal. The output of the flip-flops 724 represents the sampled DCO phase relative to the reference clock signal 702. The output of the flip-flops 724 is sent to the DPLL controller (not shown) as feedback to adjust the oscillation frequency of the DCO output. Through this feedback loop, the phase of the RF clock signal 732 from the DCO 730 gets phase-locked with the reference clock signal 702.

In the DPLL architecture in FIG. 7, the phase of RF clock signal 732 depends on the reference clock receiver 710 and buffer delay, the TDC reference clock path delay, and the TDC delay-line delay variation, and the sampled DCO phase position. Therefore, the phase of the RF clock signal 732 relative to the reference clock signal 702 is arbitrary between startups and subject to drift with temperature, device aging, etc.

All these imperfections can be calibrated after chip startup through an antenna calibration. However, the before-mentioned phase coherence across all channels within a single multi-transceiver chip and across all transceivers of the system is not met. The startup condition is not consistent within a single chip or across multiple chips, as the PLL RF clock phase and the transceiver startup are not deterministic over the power cycles. All path delays are temperature dependent, and the temperature dependence is not compensated, resulting in the necessity of frequent antenna calibrations. Dynamic start/stop of the transceivers during system operation requires antenna re-calibration.

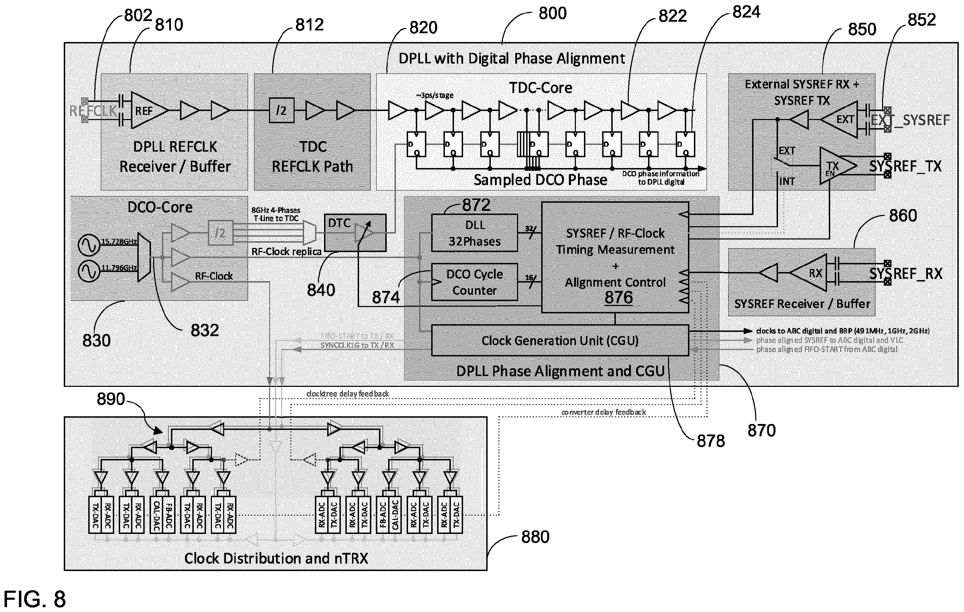

FIG. 8 shows a block diagram of an example DPLL 800 in accordance with one example. The DPLL 800 (i.e., a frequency synthesizer) includes a reference clock receiver 810, a TDC 820, a DCO 830, a digital-to-time converter (DTC) 840, a system reference clock transceiver 850, a system reference clock receiver 860, and a DPLL phase alignment and clock generation unit 870. The DCO 830 generates an RF clock signal 832 based on a PLL reference clock signal 802 and a system reference clock signal 852, and the RF clock signal 832 is distributed to the transceivers 880 via a clock distribution tree 890.

The PLL reference clock signal is a reference clock signal for the PLL 800. The system reference clock signal 852 is a different signal from the PLL reference clock signal 802. The system reference clock signal 852 is a system-wide phase synchronization signal in a multi-transceiver system. The system reference clock signal 852 has long-term deterministic phase relation across all devices (transceivers) in the system. For example, the system reference clock signal may be a low frequency system clock for baseband processing, RF data frame synchronization, etc. In examples, the PLL feedback loop for the DCO 830 is locked with the PLL reference clock signal 802, but the RF clock signal 832 generated by the DCO 830 in the individual PLLs in the system is phase-aligned relative to the system reference clock signal 852. Therefore, the RF clock signal 832 is long-term deterministic and stable in phase across all transceivers in the system.

The PLL reference clock signal 802 is received by the reference clock receiver 810 and supplied to the TDC 820 via the TDC reference clock path 812. The RF clock signal 832 (one copy of the RF clock signal 832) is supplied from the DCO 830 to the TDC 820 via the DTC 840 (i.e., a programmable delay). The TDC 820 includes a chain of delay gates 822 and a plurality of flip-flops 824. The PLL reference clock signal 802 propagates through the chain of delay gates 822. The RF clock signal 832 is supplied to the inputs of the flip-flops 824 via the DTC 840. As shown in FIG. 8, the RF clock signal 832 may be divided by a clock divider (by 2 in this example shown in FIG. 8). The TDC reference clock path 812 may also include a clock divider (by 2 in this example). Alternatively, the RF clock signal 832 or the reference clock signal 802 may not be divided or may be divided by a different factor other than two. A DTC is a device that can control time delay of an input signal by a digital code. The DTC 840 outputs a delayed replica of the RF clock signal 832 based on the control signal from the DPLL phase alignment and clock generation unit 870. The RF clock signal 832 is then sampled by the delayed chain of PLL reference clock signal. The output of the flip-flops 824, which represents the sampled DCO phase relative to the PLL reference clock signal 802, is sent to the DPLL controller (not shown) as feedback to adjust the oscillation frequency of the DCO output. The DCO 830 is synchronized with the reference clock signal 802 but the phase of the DCO output (i.e., the RF clock signal 832) is not tightly coupled with the reference clock signal 802 because of the DTC 840 inserted in the DCO feedback loop.

With the use of DTC 840 in the DCO feedback loop, the phases of the PLL reference clock signal 802 and the RF clock signal 832 are no longer tightly coupled. Through the introduction of a programmable delay element (i.e., the DTC 840) in the PLL feedback path, the phase of the DCO output (i.e., the RF clock signal 832) to the TDC 820 can be delayed as needed. As the PLL control loop keeps the phase of the feedback clock (the RF clock on the feedback path) relative to the PLL reference clock stable, the introduction of a delay in the feedback path results in a phase shift of the DCO clock in the opposite direction.

This feature is used for aligning the RF clock signal 832, which feeds the clock distribution, with a system-wide phase reference clock signal (SYSREF) 852. The DPLL phase alignment and clock generation unit 870 measures the timing of the phase of the RF clock signal 832 (i.e., the replica of the RF clock signal) relative to the phase of the system reference clock signal 852 (SYSREF) in a digital way and sends a control signal to the DTC 840 to adjust the delay to the RF clock signal 830 on the DCO feedback path. With the programmable delay element (i.e., the DTC 840) in the DCO feedback path, the phase of the RF clock signal 832 does not have to be tightly coupled to the PLL reference clock signal 802 but can be adjusted in a desired way relative to the system reference clock signal.

The DPLL phase alignment and clock generation unit 870 includes a delay-locked loop (DLL) 872, a DCO cycle counter 874, a timing measurement and alignment control unit 876, and a clock generation unit 878. The DPLL phase alignment and clock generation unit 870 receives the RF clock signal (a replica of the RF clock signal 832 distributed to the transceivers 880) from the DCO 830. The DCO cycle counter 874 counts the number of clock cycles of the RF clock signal 832 per cycle of the system reference clock 852 or 860. The RF clock signal 832 propagates through the DLL 872. A DLL 872 is a chain of delay gates, where the delay of the delay gates is controlled by an analog or digital feedback loop in a way that the output clock of the last delay gate matches the input clock of the DLL. So, the phase at the output of the last delay gate is delayed by one period of the input clock. Let N be the total number of the delay gates in the DLL and T be the period of the DLL input clock and k be the index of the respective delay cell, then the phase of the respective clock at the output of delay cell k is k^{∗}(T/N). For example, if the DLL has 32 delay gates and the period of the input clock is 64ps the DLL generates 32 phases of the input clock at the outputs of the delay gates, each delayed by 64ps / 32 = 2ps relative to the output of the delay cell before in the chain. The timing measurement and alignment control unit 876 takes the outputs of the DCO cycle counter and the DLL for measuring the time when the system reference clock 852 or 860 has a transition with very high accuracy (determined by the number of DLL phases). Through averaging over multiple periods of the system reference clock the accuracy can be increased further. Based on this measurement the feedback signal 874 to the DTC 840 is generated. It controls the phase of the DPLL feedback clock to the TDC 820 and hence the phase of the DCO output clock 832 through the DPLL feedback loop, which keeps the TDC measurement value constant. The time measurement with DCO cycle counter and DPLL is only an exemplary implementation, and other ways are possible.

The timing measurement and alignment control unit 876 measures the timing of the phase of the RF clock signal 832 relative to the phase of the system reference clock 852. The timing measurement and alignment control unit 876 sends a control signal to the DTC 840 and also to the clock generation unit 878 based on the measured timing of the phase of the RF clock signal 832 relative to the phase of the system reference clock 852. The clock generation unit 878 may then generate/synthesize one or more clock signals that are phase-aligned with the system reference clock signal 852 using the RF clock signal 832 based on the control signal. The clock generation unit 878 receives the RF clock signal 832 from the DCO 830 and may synthesize one or more clock signals based on the control signal from the timing measurement and alignment control unit 876. For example, the clock generation unit 878 may generate and supply digital clocks that are phase aligned with the system reference clock signal 852 to a digital baseband processor as reference for digital system time alignment. The clock generation unit 878 may also generate a signal for clock divider synchronization across all analog TX and RX channels, and/or signals for synchronous data first-in first-out (FIFO) access across all analog TX and RX channels, or the like.

In examples, feedback (clock tree delay feedback) may be sent from the clock distribution tree 890 to the timing measurement and alignment control unit 876 and feedback (converter delay feedback) may be sent from the ADCs and DACs in the transceivers 880 to the timing measurement and alignment control unit 876. The timing management and alignment control unit 876 may then adjust the timing of the clock signals distributed to the transceivers 880 based on the feedback. The delays (the clock tree delay and/or the converter delay) may be tracked, and the delay drift may be compensated by the timing measurement and alignment control unit 870.

In order to not degrade the PLL phase-noise performance, the delay resolution of the DTC 840 needs to be very small relative to the PLL integrated jitter, at least one order of magnitude smaller (fs-range) and the bandwidth of the RF clock phase control loop needs to be very small relative to the PLL bandwidth (kHz range).

The system reference clock signal 852 may be received from the external clock source (not shown). The system reference clock transceiver 850 may receive an external system reference clock 852 and supply it to the timing management and alignment control unit 876. Alternatively, the system reference clock may be received from another PLL in the system (e.g., from another PLL in the same chip, in the different chip, or in different package). In this case, the system reference clock receiver 860 may receive the system reference clock from another PLL in the system and supply it to the timing management and alignment control unit 876. The timing management and alignment control unit 876 may transmit the system reference clock signal to another PLL in the system via the system reference clock transceiver 850.

The DPLL phase alignment and clock generation unit 870 also has the capability of digitally generating a virtual SYSREF signal as reference for RF clock delay alignment based on the measurement of consecutive/multiple incoming SYSREF pulses. For example, the virtual SYSREF signal may be calculated through taking the average of the arrival times of first and consecutive SYSREF pulses at 852 or 860 and adding some time offset depending on other system properties like temperature, voltage, or process corner of the silicon. For example, the average of first and consecutive SYSREF pulses are taken such that the first virtual SYSREF pulse would be at (t1+t2)/2+toffset1, the second would be at (t3+t4)/2+toffset2, ..., and so on, where t1,t2,t3,t4,... denote the measured arrival times of SYSREF pulses on 852 or 860. The DPLL phase alignment and clock generation unit 870 also has the capability of enhancing the accuracy of the SYSREF time measurement by calculating the average across a multitude of received SYSREF pulses and calculating the frequency of the incoming SYSREF pulses and include the knowledge about the frequency of the incoming SYSREF pulses in above calculations.

In the examples disclosed above, the phases of the PLL reference clock and the RF clock generated by the DCO may be decoupled by including the programmable delay (DTC) in the DCO feedback path. With the disclosed schemes, low phase noise reference clock distribution is enabled. No reference clock distribution buffers are needed for reference clock phase alignment, which can reduce the BOM. The reference clock distribution does not have to be delay-matched between multiple PLLs. No additional delay buffers may be needed in the RF clock signal path, avoiding phase noise degradation. The delay control may be performed over the phase of the feedback clock (the RF clock on the DCO feedback path).

The phase of the RF clock is digitally aligned relative to the external phase synchronization reference SYSREF. The alignment is done in digital domain, (i.e., the phase of the SYSREF is measured in relation to the RF clock in digital domain).

Low bandwidth background phase control loop and ultra-fine delay adjustment (fs range) are possible. The phase measurement may be enhanced through averaging. The background phase control does not interfere with the main PLL phase control loop.

The phase of the RF clock relative to the SYSREF is long term stable, is coherent between startups, and temperature drift/device aging may be tracked and compensated. Delay of clock distribution may be tracked via feedback path and compensated. Delay of data converters can be tracked and compensated.

The clock generation unit 878 generates digital clocks that is phase aligned with the SYSREF to other components as reference for digital system time alignment. The SYSREF is synchronous to the digital clock for sampling without metastability. This may be sufficient for deterministic and phase-aligned operation of all digital TX and RX chains within a single transceiver chip and across all transceivers in the system. The clock generation unit 878 may generate, in addition to the RF clock signal, a signal for clock divider synchronization across all analog TX and RX channels, signals for synchronous data FIFO access across all analog TX and RX channels, or the like.

The disclosed system for phase aligning the frequency synthesizer (PLL) RF output clocks reduces system complexity, BOM for external clock distribution devices, and improves phase stability over temperature gradients, resulting in less frequent re-calibration.

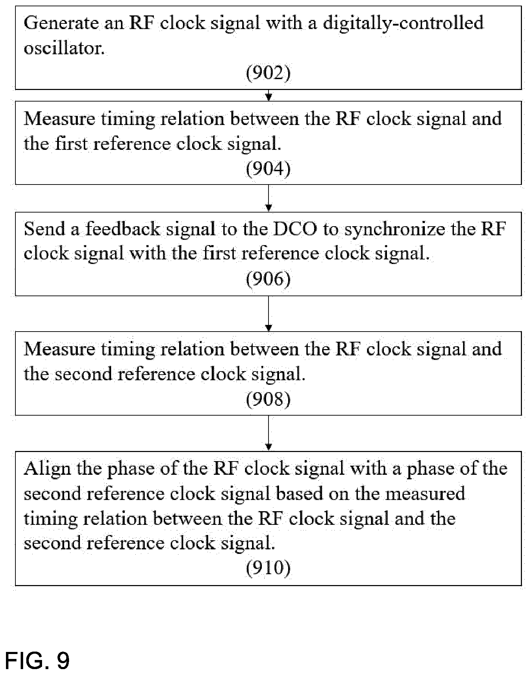

FIG. 9 is a flow diagram of an example method for generating an RF clock signal in a system including a plurality of transceiver units that are configured to receive and transmit from and to a plurality of antennas. Each transceiver unit includes at least one DAC, at least one ADC, and a frequency synthesizer. A frequency synthesizer in each transceiver unit receives a first reference clock signal from a reference clock generator and a second, different, reference clock signal. The method includes generating an RF clock signal with a DCO (902). The method includes measuring timing relation between the RF clock signal and the first reference clock signal (904). The method includes sending a feedback signal to the DCO to synchronize the RF clock signal with the first reference clock signal (906). The first reference clock signal is used for frequency locking the DCO to an integer or fractional multiple of the first reference clock signal. The method includes measuring timing relation between the RF clock signal and the second reference clock signal (908). The method includes aligning the phase of the RF clock signal with a phase of the second reference clock signal based on the measured timing relation between the RF clock signal and the second reference clock signal (910). The phase of the DCO output is aligned relative to the second reference clock signal with a slow (low bandwidth) background phase control/tracking loop. The second reference clock signal is a system-wide reference clock signal for the plurality of transceiver units.

The RF clock signal may be delayed using a programmable delay based on a control signal from the phase alignment and clock generation circuitry. The programmable delay may be included in a feedback path of the DCO or in a signal path of the RF clock signal to the at least one ADC and the at least one DAC.

The examples disclosed herein provide advantages over the conventional system. The synthesizer RF clock output is aligned to the system synchronization signal (SYSREF). Therefore, phase alignment of the reference clock between the PLLs is not required, there is no need for delay matched reference clock distribution, reference clock phase noise is improved as clock distribution buffers which would contribute to reference clock phase noise and supply pushing are not required, and it needs reduced BOM (no reference clock distribution buffers).

In examples, a system synchronization signal SYSREF that is commonly available in massive MIMO or phased array systems, is the reference for the RF clock phase alignment. The RF clock phase alignment scheme of the examples may be implemented for all-digital-PLLs but is also applicable to analog PLLs working in integer or fractional mode. Phase alignment works independent of integer and fractional mode operation. Phase is adjusted in fully digital way, allowing PLL individual phase offset and temperature dependent phase tracking and compensation. Compensation of transceiver phase variation is possible through additional delay feedback paths. A system wide RF clock phase coherence is improved. Less frequent antenna calibration may be needed as transceiver phase is inherently stable.

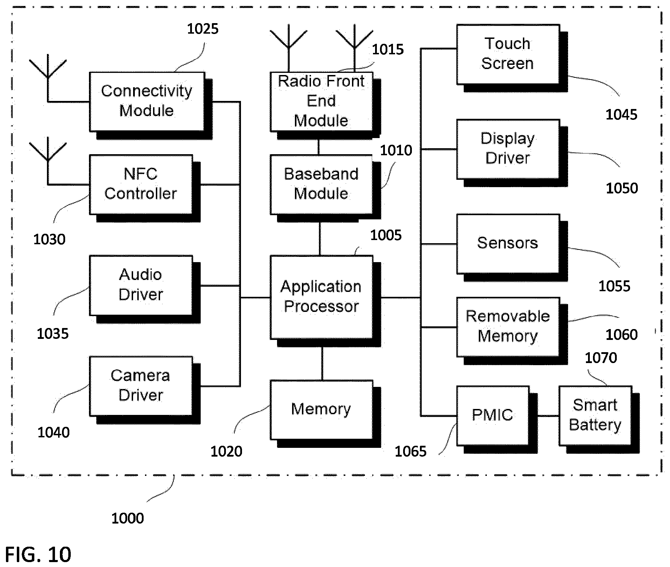

FIG. 10 illustrates a user device 1000 in which the examples disclosed herein may be implemented. For example, the examples disclosed herein may be implemented in the radio front-end module 1015, in the baseband module 1010, etc. The user device 1000 may be a mobile device in some aspects and includes an application processor 1005, baseband processor 1010 (also referred to as a baseband module), radio front end module (RFEM) 1015, memory 1020, connectivity module 1025, near field communication (NFC) controller 1030, audio driver 1035, camera driver 1040, touch screen 1045, display driver 1050, sensors 1055, removable memory 1060, power management integrated circuit (PMIC) 1065 and smart battery 1070.

In some aspects, application processor 1005 may include, for example, one or more CPU cores and one or more of cache memory, low drop-out voltage regulators (LDOs), interrupt controllers, serial interfaces such as serial peripheral interface (SPI), inter-integrated circuit (I2C) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 1010 may be implemented, for example, as a solder-down substrate including one or more integrated circuits, a single packaged integrated circuit soldered to a main circuit board, and/or a multi-chip module containing two or more integrated circuits.

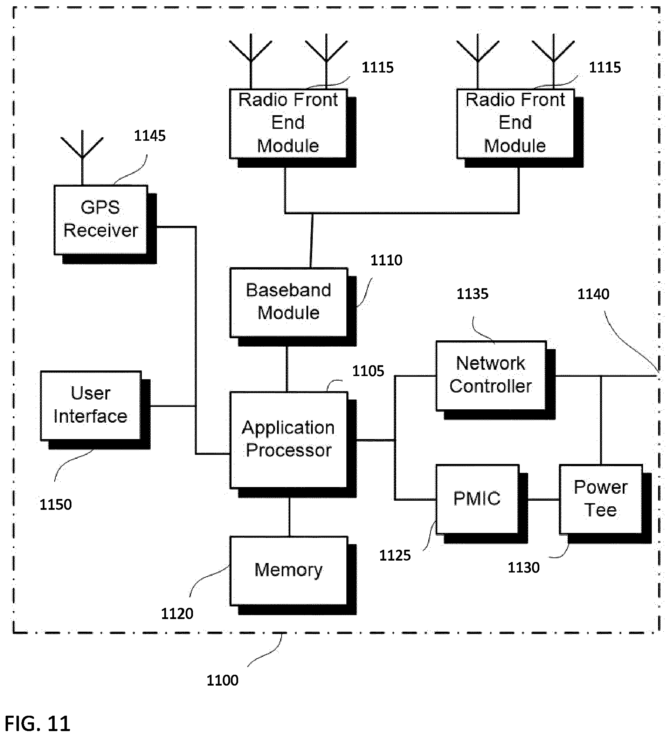

FIG. 11 illustrates a base station or infrastructure equipment radio head 1100 in which the examples disclosed herein may be implemented. For example, the examples disclosed herein may be implemented in the radio front-end module 1115, in the baseband module 1110, etc. The base station radio head 1100 may include one or more of application processor 1105, baseband modules 1110, one or more radio front end modules 1115, memory 1120, power management circuitry 1125, power tee circuitry 1130, network controller 1135, network interface connector 1140, satellite navigation receiver module 1145, and user interface 1150.

In some aspects, application processor 1105 may include one or more CPU cores and one or more of cache memory, low drop-out voltage regulators (LDOs), interrupt controllers, serial interfaces such as SPI, I2C or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 1110 may be implemented, for example, as a solder-down substrate including one or more integrated circuits, a single packaged integrated circuit soldered to a main circuit board or a multi-chip module containing two or more integrated circuits.

In some aspects, memory 1120 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magneto resistive random access memory (MRAM) and/or a three-dimensional crosspoint memory. Memory 1120 may be implemented as one or more of solder down packaged integrated circuits, socketed memory modules and plug-in memory cards.

In some aspects, power management integrated circuitry 1125 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 1130 may provide for electrical power drawn from a network cable to provide both power supply and data connectivity to the base station radio head 1100 using a single cable.

In some aspects, network controller 1135 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 1145 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 1145 may provide data to application processor 1105 which may include one or more of position data or time data. Application processor 1105 may use time data to synchronize operations with other radio base stations.

In some aspects, user interface 1150 may include one or more of physical or virtual buttons, such as a reset button, one or more indicators such as light emitting diodes (LEDs) and a display screen.

Another example is a computer program having a program code for performing at least one of the methods described herein, when the computer program is executed on a computer, a processor, or a programmable hardware component. Another example is a machine-readable storage including machine readable instructions, when executed, to implement a method or realize an apparatus as described herein. A further example is a machine-readable medium including code, when executed, to cause a machine to perform any of the methods described herein.

The examples as described herein may be summarized as follows:

An example (e.g., example 1) relates to a frequency synthesizer in a system including a plurality of transceivers that are configured to receive and transmit from and to a plurality of antennas. Each transceiver may include at least one DAC, at least one ADC, and a frequency synthesizer. A frequency synthesizer in each transceiver receives a first reference clock signal and a second, different, reference clock signal. The frequency synthesizer may include a DCO (510/830) configured to generate an RF clock signal, a feedback circuitry (520) configured to measure timing relation between the RF clock signal and the first reference clock signal and send a feedback signal to the DCO (510/830) to synchronize the RF clock signal with the first reference clock signal, and a phase alignment and clock generation circuitry (530/870) configured to measure timing relation between the RF clock signal and the second reference clock signal and align the phase of the RF clock signal with a phase of the second reference clock signal based on the measured timing relation between the RF clock signal and the second reference clock signal. The second reference clock signal is a system-wide reference clock signal for the plurality of transceivers.

Another example, (e.g., example 2) relates to a previously described example (e.g., example 1), wherein the frequency synthesizer may further include a programmable delay configured to delay the RF clock signal based on a control signal from the phase alignment and clock generation circuitry.

Another example, (e.g., example 3) relates to a previously described example (e.g., example 2), wherein the programmable delay is included in the feedback circuitry (520).

Another example, (e.g., example 4) relates to a previously described example (e.g., any one of examples 2 or 3), wherein the programmable delay is included in a signal path of the RF clock signal to the at least one ADC and/or the at least one DAC.

Another example, (e.g., example 5) relates to a previously described example (e.g., example 2-4), wherein the programmable delay is a digital-to-time converter (840).

Another example, (e.g., example 6) relates to a previously described example (e.g., any one of examples 1-5), wherein the feedback circuitry (520) includes a TDC (820) for measuring the timing relation between the RF clock signal and the first reference clock signal.

Another example, (e.g., example 7) relates to a previously described example (e.g., example 6), wherein the TDC (820) includes a chain of delay buffers (822) and a plurality flip-flops (824), wherein the first reference clock signal is input into the chain of delay buffers (822) and the RF clock signal is sampled to the plurality of flip-flops (824) by the first reference clock signal in the chain of delay buffers (822).

Another example, (e.g., example 8) relates to a previously described example (e.g., example 1-7), wherein the phase alignment and clock generation circuitry (530/870) is configured to generate at least one additional clock signal that is in phase with the second reference clock signal and supply the at least one additional clock signal to the ADC and the DAC and/or to baseband processing components.

Another example, (e.g., example 9) relates to a previously described example (e.g., example 1-8), wherein the RF clock signal is distributed to the ADC and the DAC via a clock distribution tree (890).

Another example, (e.g., example 10) relates to a previously described example (e.g., example 1-9), wherein the phase alignment and clock generation circuitry (530/870) is configured to receive the second reference clock signal from an external clock source or from another transceiver.

Another example, (e.g., example 11) relates to a previously described example (e.g., example 1-10), wherein the phase alignment and clock generation circuitry (530/870) is configured to send the second reference clock signal to another transceiver.

Another example, (e.g., example 12) relates to a method for generating an RF clock signal in a system including a plurality of transceivers that are configured to receive and transmit from and to a plurality of antennas. Each transceiver may include at least one DAC, at least one ADC, and a frequency synthesizer. A frequency synthesizer in each transceiver receives a first reference clock signal from a reference clock generator and a second, different, reference clock signal. The method includes generating an RF clock signal with a DCO (510/830), measuring timing relation between the RF clock signal and the first reference clock signal, sending a feedback signal to the DCO (510/830) to synchronize the RF clock signal with the first reference clock signal, measuring timing relation between the RF clock signal and the second reference clock signal, and aligning the phase of the RF clock signal with a phase of the second reference clock signal based on the measured timing relation between the RF clock signal and the second reference clock signal. The second reference clock signal is a system-wide reference clock signal for the plurality of transceivers.

Another example, (e.g., example 13) relates to a previously described example (e.g., example 12), wherein the RF clock signal is delayed using a programmable delay based on a control signal from the phase alignment and clock generation circuitry.

Another example, (e.g., example 14) relates to a previously described example (e.g., example 13), wherein the programmable delay is included in a feedback path of the DCO (510/830) or in a signal path of the RF clock signal to the at least one ADC and/or the at least one DAC.

Another example, (e.g., example 15) relates to a machine-readable storage including machine readable instructions, when executed, to implement a method as in any one of examples 12-14.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A frequency synthesizer comprising:
a digitally-controlled oscillator, DCO, (510/830) configured to generate a radio frequency, RF, clock signal;
a feedback circuitry (520) configured to measure timing relation between the RF clock signal and a first reference clock signal and send a feedback signal to the DCO (510/830) to synchronize the RF clock signal with the first reference clock signal; and
a phase alignment and clock generation circuitry (530/870) configured to measure timing relation between the RF clock signal and a second, different, reference clock signal and align the phase of the RF clock signal with a phase of the second reference clock signal based on the measured timing relation between the RF clock signal and the second reference clock signal,
wherein the second reference clock signal is a system-wide reference clock signal for a plurality of transceivers.

2. The frequency synthesizer of claim 1 further comprising:
a programmable delay configured to delay the RF clock signal based on a control signal from the phase alignment and clock generation circuitry.

3. The frequency synthesizer of claim 2, wherein the programmable delay is included in the feedback circuitry (520).

4. The frequency synthesizer of claim 2, wherein the programmable delay is included in a signal path of the RF clock signal to at least one analog-to-digital converter, ADC, and/or at least one digital-to-analog converter, DAC.

5. The frequency synthesizer as in any one of claims 2-4, wherein the programmable delay is a digital-to-time converter (840).

6. The frequency synthesizer as in any one of claims 1-5, wherein the feedback circuitry (520) includes a time-to-digital converter, TDC, (820) for measuring the timing relation between the RF clock signal and the first reference clock signal.

7. The frequency synthesizer of claim 6, wherein the TDC (820) includes a chain of delay buffers (822) and a plurality flip-flops (824), wherein the first reference clock signal is input into the chain of delay buffers (822) and the RF clock signal is sampled to the plurality of flip-flops (824) by the first reference clock signal in the chain of delay buffers (822).

8. The frequency synthesizer as in any one of claims 1-7, wherein the phase alignment and clock generation circuitry (530/870) is configured to generate at least one additional clock signal that is in phase with the second reference clock signal and supply the at least one additional clock signal to an analog-to-digital converter and a digital-to-analog converter and/or to baseband processing components.

9. The frequency synthesizer of claim 1, wherein the RF clock signal is distributed to an analog-to-digital converter and a digital-to-analog converter via a clock distribution tree (890).

10. The frequency synthesizer as in any one of claims 1-9, wherein the phase alignment and clock generation circuitry (530/870) is configured to receive the second reference clock signal from an external clock source or from another transceiver.

11. The frequency synthesizer as in any one of claims 1-10, wherein the phase alignment and clock generation circuitry (530/870) is configured to send the second reference clock signal to another transceiver.

12. A method for generating a radio frequency, RF, clock signal in a system including a plurality of transceivers that are configured to receive and transmit from and to a plurality of antennas, the method comprising:
generating an RF clock signal with a digitally-controlled oscillator, DCO, (510/830);
measuring timing relation between the RF clock signal and a first reference clock signal;
sending a feedback signal to the DCO (510/830) to synchronize the RF clock signal with the first reference clock signal;
measuring timing relation between the RF clock signal and a second, different, reference clock signal; and
aligning the phase of the RF clock signal with a phase of the second reference clock signal based on the measured timing relation between the RF clock signal and the second reference clock signal,
wherein the second reference clock signal is a system-wide reference clock signal for a plurality of transceivers.

13. The method of claim 12, wherein the RF clock signal is delayed using a programmable delay based on a control signal from the phase alignment and clock generation circuitry.

14. The method of claim 13, wherein the programmable delay is included in a feedback path of the DCO (510/830) or in a signal path of the RF clock signal to at least one analog-to-digital converter, ADC, and/or at least one digital-to-analog converter, DAC.

15. A machine-readable storage including machine readable instructions, when executed, to implement a method as in any one of claims 12-14.
